# EUROPÄISCHE PATENTSCHRIFT

(11) **EP 0 537 314 B1**
(45) Veröffentlichungstag und Bekanntmachung des Hinweises auf die Patenterteilung: **29.11.1995**
(21) Anmeldenummer: 92909117.1
(22) Anmeldetag: 23.04.1992
(51) Int. Cl.: H01F 5/04

(54) **SPULENKÖRPER UND VERFAHREN ZU SEINER HERSTELLUNG**
COIL FORMER AND PROCESS FOR PROCUCING IT
MANDRIN DE BOBINE ET PROCEDE POUR SA FABRICATION

(30) Priorität: 03.05.1991 DE 4114391
(43) Veröffentlichungstag der Anmeldung: 21.04.1993
(73) Patentinhaber: HOHENLOHER KUNSTSTOFFTECHNIK GmbH & Co., 74613 Öhringen (DE)
(72) Erfinder: LEHMANN, Eberhard, D-7114 Pfedelbach-Windischenbach (DE)
(74) Vertreter: Lins, Edgar, Dipl.-Phys. Dr.jur.
(86) Internationale Anmeldenummer: DE9200335
(87) Internationale Veröffentlichungsnummer: WO9220079

(56) Entgegenhaltungen:
- EP-A- 0 415 643
- GB-A- 2 135 527

## Beschreibung

Die Erfindung betrifft einen Spulenkörper mit in einem unteren Flansch eingespritzten Enden von zur Durchsteckkontaktierung geeigneten Anschlußstiften, die in einem Abschnitt unterhalb des unteren Flansches mit Enden von Spulenwickeldrähten umwikkelbar sind. Die Erfindung betrifft ferner ein Verfahren zur Herstellung eines solchen Spulenkörpers.

Für die herkömmliche Kontaktierung von elektronischen Bauelementen auf Bestückungsplatten sind die Platten mit Bohrungen versehen worden, durch die Anschlußstifte hindurchragten und auf der Unterseite der Platte mit von den Bohrungen durchbohrten Kontaktflächen von gedruckten Leiterbahnen verlötet wurden. Ein dafür geeigneter Spulenkörper mit in einem unteren Flansch verankerten Anschlußstiften ist z.B. aus EP-A-0 415 643 bekannt. Demgegenüber setzt sich zunehmend die Oberflächenkontaktierung solcher Bestückungsplatten durch, bei der die Bauelemente unmittelbar auf Kontaktflächen der Platte aufgesetzt und dort verlötet werden. Gegebenenfalls kann das Bauelement auf der Platte durch Aufkleben zusätzlich fixiert werden. Für diese Art der Kontaktierung müssen die Bauelemente mit geeigneten Anschlüssen versehen sein. Hierzu werden regelmäßig streifenförmige Anschlüsse verwendet, die in dem Gehäuse des Bauelements verankert werden und außerhalb des Gehäuses abgewinkelt sind. Regelmäßig werden diese Anschlüsse seitlich aus dem Gehäuse herausgeführt, nach unten und anschließend wieder nach außen abgewinkelt. Es hat sich gezeigt, daß eine automatische Bestückung von mit einem Duroplasten gebildeten Bauteil, beispielsweise einem duroplastischen Spulenkörper, mit derartigen Blechstreifen nicht zu realisieren ist, da die Abdichtung des Werkzeugs nicht gelingt, so daß immer duroplastisches Material austritt, das in einem anschließenden Bearbeitungsvorgang vom Bauelement wieder entfernt werden muß. Darüber hinaus sind die aus Blechstreifen gebildeten Anschlüsse bei einer Verwendung an einem Spulenkörper bei der Bewicklung des Spulenkörpers anfällig und verformen sich leicht in Richtung der Biegungen, so daß die Anschlüsse mit ihren nach außen abgebogenen Enden nicht mehr plan auf der Kontaktfläche aufliegen und daher keine sichere Kontaktierung mehr gewährleisten.

Es ist auch bekannt, herkömmliche Gehäuse mit streifenförmigen Anschlußbeinen, die in eine passende Fassung einsteckbar sind, dadurch oberflächenmontierbar zu machen, daß die Anschlußbeine umgebogen werden. Hierdurch entsteht eine den oben erwähnten streifenförmigen Anschlüssen für die Oberflächenmontage vergleichbare Anordnung.

Aufgrund der Probleme mit den bekannten streifenförmigen Anschlüssen ist vorgeschlagen worden, die Anschlüsse von oberflächenmontierbaren Bauelementen durch Stifte mit einem relativ großen Querschnitt und einem im Querschnitt stufenförmig erweiterten unteren Ende (das im Höhenschnitt eine T-Form verursacht) durchzuführen. Der hierfür erforderliche Kostenaufwand ist hoch und für die große Anzahl der benötigten Anschlüsse wirtschaftlich nicht zu realisieren.

Der Erfindung liegt die Aufgabe zugrunde, einen Spulenkörper zu schaffen, der die oben beschriebenen Nachteile weitgehend vermeidet.

Diese Aufgabe wird erfindungsgemäß mit einem Spulenkörper der eingangs erwähnten Art gelöst, der dadurch gekennzeichnet ist, daß die Anschlußstifte unterhalb des Abschnitts zu einem rechteckigen Querschnitt abgeplattet und im Bereich des abgeplatteten Querschnitts zur Bildung von oberflächenmontierbaren Anschlüssen abgewinkelt sind.

Die genannte Aufgabe wird ferner mit einem Verfahren zur Herstellung eines Spulenkörpers gelöst, bei dem ein herkömmlicher, für die Durchstecktechnik verwendbarer Stift in herkömmlicher Technik im unteren Flansch des Spulenkörpers verankert wird, bei dem das freie Ende des aus dem Flansch herausstehenden Teils des Anschlußstifts unterhalb des zur Umwicklung vorgesehenen Abschnitts des Anschlußstifts durch Pressen abgeplattet wird und bei dem der abgeplattete Teil des Anschlußstifts zur Bildung eines oberflächenmontierbaren Anschlusses abgewinkelt wird.

Die Erfindung bietet den Vorteil, daß ein Spulenkörper für die Oberflächenkontaktierung prinzipiell in gleicher Weise wie ein Spulenkörper für die herkömmliche Durchsteck-Verbindungstechnik herstellbar ist und daß anschließend die für die Durchstecktechnik verwendbaren Stifte abgeplattet und umgebogen werden können, so daß dann ein für die Oberflächenmontage geeignetes Bauelement geschaffen ist. Es ist daher möglich, die Spulenkörper für die bisherige Durchsteckkontaktierung und die Oberflächenkontaktierung in prinzipiell der gleichen Weise herzustellen und mit Anschlüssen zu versehen. Dabei ist es lediglich erforderlich, die Anschlüsse des für die Oberflächenmontage vorgesehenen Spulenkörpers anschließend zu bearbeiten und in der erwähnten Weise auszubilden. Des weiteren ergibt sich der Vorteil, daß die Anschlüsse in Form von Anschlußstiften nach unten aus dem Spulenkörper herausgeführt und dann abgebogen sein können. Gegenüber der seitlichen Herausführung von streifenförmigen Anschlüssen, die zunächst nach unten und dann wieder nach außen abgebogen sind, ergibt sich eine erhebliche Einsparung des auf der Platte benötigten Platzes, die bei kleinen Spulenkörpern bis zu einem Drittel betragen kann.

Die erfindungsgemäße Ausbildung eines Spulenkörpers ist besonders vorteilhaft, weil ein stabiler Abschnitt des Anschlusses für die Umwicklung mit dem Ende des Spulendrahts zur Verfügung steht, so daß der Anschluß mechanisch wenig anfällig gegen eine Verbiegung bei der Herstellung des Anschlusses ist. Bei einer Ausbildung des aus dem Spulenkörper herausragenden Teils des Anschlusses mit einem quadratischen Querschnitt vor der Abplattung wird in bekannter Weise eine besonders günstige Geometrie für das Anwickeln des Spulendrahtes gewährleistet.

Die Zuführung drahtförmiger Anschlußstifte beispielsweise bei der Herstellung eines Spulenkörpers in die Spritzform geschieht in der herkömmlichen Technik und wirft keine Probleme auf. Es müssen daher erfindungsgemäß nicht teure und neue Anschlußstifte mit veränderten Querschnitten gehandhabt werden, die gegebenenfalls ausgerichtet und in einer bestimmten Lage zugeführt werden müssen, wodurch der Aufwand noch vergrößert wird.

Besonders vorteilhaft ist es, wenn die Anschlüsse, die sich an mindestens zwei Außenseiten des Spulenkörpers befinden, dadurch abgeplattet werden, daß an der Innenseite der Anschlüsse ein Gegenhalter positioniert und mit einem Preßstempel von außen gegen den ortsfest gehaltenen Gegenhalter gedrückt werden. Dadurch bildet sich durch die Abplattung eine Stufe an der Außenseite des Anschlusses aus. Im allgemeinen wird der Gegenhalter dabei als ein Stück zwischen die Anschlüsse gefahren werden und anschließend die Preßstempel von außen die Anschlüsse gegen den Gegenhalter drücken, wodurch die gewünschte Verformung im Sinne der Abplattung erfolgt. Die Erfindung erlaubt nicht nur die Verwendung eines gleichen Herstellungsverfahrens und die Verwendung gegebenenfalls gleicher Gehäuse für die Spulenkörper, sondern bei deren auch die Verwendung identischer Wickelautomaten. Das erfindungsgemäße Verfahren ist ohne die Ausübung größerer Kräfte auf den Spulenkörper selbst ausführbar, so daß die Verankerung der Anschlüsse darin bei einer anschließenden Verformung der Anschlußstifte nicht in riskanter Weise belastet wird.

Die erfindungsgemäßen Anschlüsse lassen sich sehr präzise herstellen. So ist es beispielsweise möglich, die Abwinkelung des abgeplatteten Anschlußstiftes so durchzuführen, daß zwischen der Kontaktfläche und der Auflagefläche des Anschlusses ein kleiner Winkel ausgebildet wird, wodurch das Lötmaterial aufgrund einer gewissen Kapillarwirkung verbessert in den Bereich des Anschlusses einfließt, das zu einer erhöhten Sicherheit der Lötverbindung führt.

Die Erfindung wird im folgenden anhand von in der Zeichnung dargestellten Ausführungsbeispielen näher erläutert. Es zeigt:
- Figur 1 -: einen in ein Bauelement eingebetteten Anschlußstift in vier Bearbeitungsphasen
- Figur 2 -: eine Seitenansicht eines Spulenkörpers mit verankerten Anschlußstiften
- Figur 3 -: den Spulenkörper gemäß Figur 2 mit gekürzten Anschlußstiften
- Figur 4 -: den Spulenkörper gemäß Figur 3 nach einer Abplattung der Anschlußstifte durch einen Preßvorgang
- Figur 5 -: den Spulenkörper mit nach außen abgewinkelten Anschlüssen
- Figur 6 -: eine Draufsicht auf den Spulenkörper gemäß Figur 5.

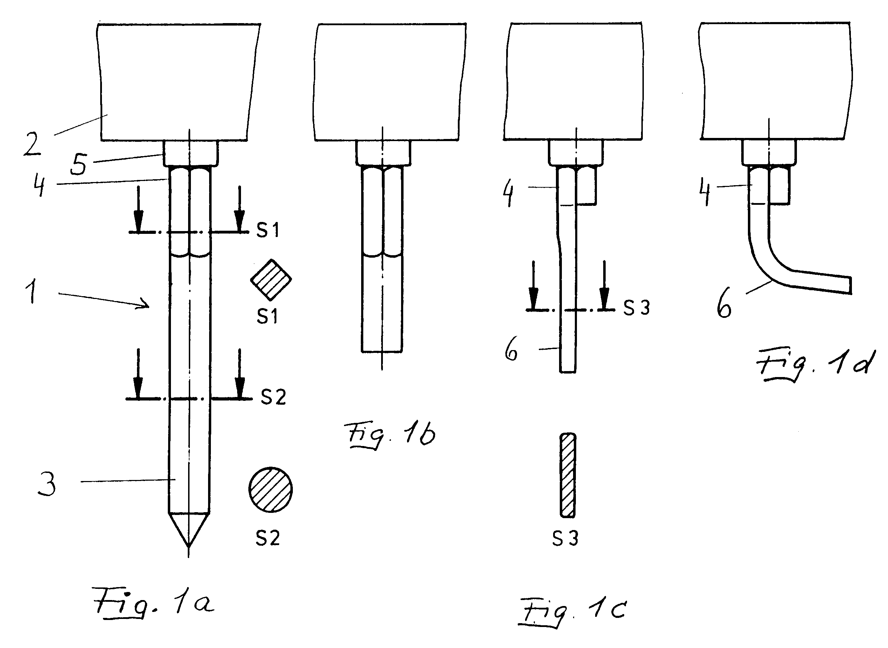

Figur 1 zeigt einen Anschluß 1, der in einem Spulenkörper 2 verankert ist. Dies geschieht im allgemeinen dadurch, daß bei der Herstellung des z.B. als Kunststoff-Bauelement vorliegenden Spulenkörpers der Anschluß in eine Spritzform für die Herstellung dieses Bauelements eingelegt und somit teilweise eingespritzt wird. Im vorliegenden Fall besteht der Anschluß aus einem Stift 3 mit einem runden Querschnitt, wie er sich aus der Darstellung des Schnittes S2 in Figur 1 ergibt. Am oberen Ende ist der Stift 3 im Abschnitt 4 zu einem Vierkant mit quadratischem Querschnitt geprägt, wie er aus der Darstellung des Schnittes S1 hervorgeht. Mit einem runden Sockel 5 ist der Anschluß 1 in dem Spulenkörper verankert. Der Anschluß 1 ist in der in Figur 1a dargestellten Form ein üblicher Stift 3, wie er für die herkömmliche Durchsteck-Kontaktierung eingesetzt wird.

Zur Verwendung eines solchen Anschlusses 1 für eine Oberflächenmontage wird in einem ersten Schritt der Anschlußstift 3 durch Abschneiden eines Endes gekürzt, wie dies in Figur 1b gezeigt ist. Das Kürzen erfolgt mit Abstand unterhalb des Vierkantbereichs 4 im Bereich des runden Querschnitts S2.

Im folgenden Verfahrensschritt wird das freie Ende des Anschlusses 1 einer Abplattung durch einen Preßvorgang unterworfen, wodurch unterhalb eines verbleibenden Stückes des Vierkantbereichs 4 ein im Querschnitt rechteckiges Anschlußstück 6 verbleibt, dessen Querschnitt als Schnitt S3 in Figur 1 dargestellt ist. Figur 1c läßt erkennen, daß die Verformung zu dem rechteckigen Querschnitt gemäß S3 im wesentlichen durch eine Preßbewegung von außen nach innen gegen ein feststehendes Gegenlager auf der Innenseite des Anschlusses 1 erfolgt ist.

Im Anschluß daran wird das Anschlußstück 6 mit Abstand von dem verbliebenen Vierkantbereich 4 im wesentlichen rechtwinkelig nach außen abgebogen, wobei ein spitzer Winkel gegenüber einer ebenen Auflagefläche vorteilhaft ist. Der verbliebene Vierkantbereich 4 läßt sich mit Vorteil mit den Enden eines Spulenwickeldrahtes umwickeln, um die elektrische Verbindung zur Spule herzustellen. Die Umwicklung erfolgt in dem stabilen Vierkantbereicht 4, so daß das gebogene Anschlußteil 6 durch den Wickelvorgang nicht beeinträchtigt wird.

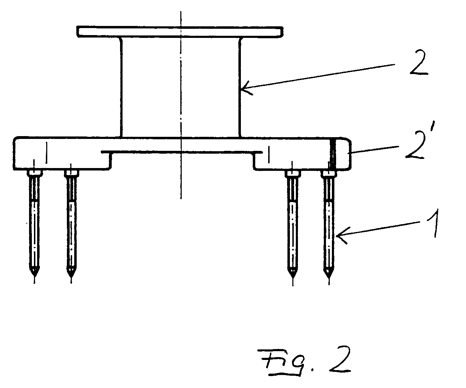

Figur 2 zeigt den Zustand gemäß Figur 1a an einem Spulenkörper 2 als elektronisches Bauelement. Die als Anschlußstifte ausgebildeten Anschlüsse 1 sind in angesetzten Flanschen 2′ des Spulenkörpers 2 eingespritzt.

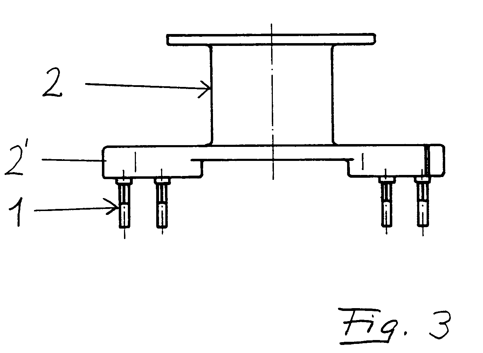

Figur 3 zeigt den Zustand der Anschlüsse 1 nach dem Kürzen der Anschlußstifte 3 gemäß Figur 1b.

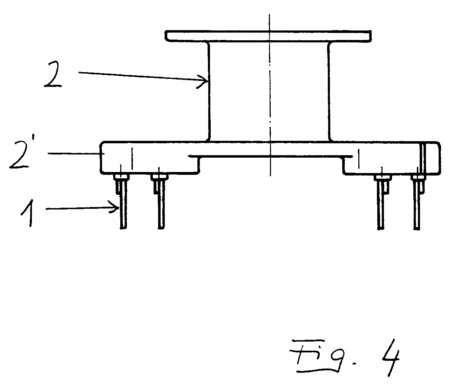

Figur 4 verdeutlicht die Abplattung der Anschlüsse 1 gemäß Figur 1c, wobei deutlich wird, daß die Materialverdrängung von außen nach innen erfolgt ist, also ein Preßstempel sich von außen nach innen gegen einen innen angeordneten Gegenhalter bewegt hat.

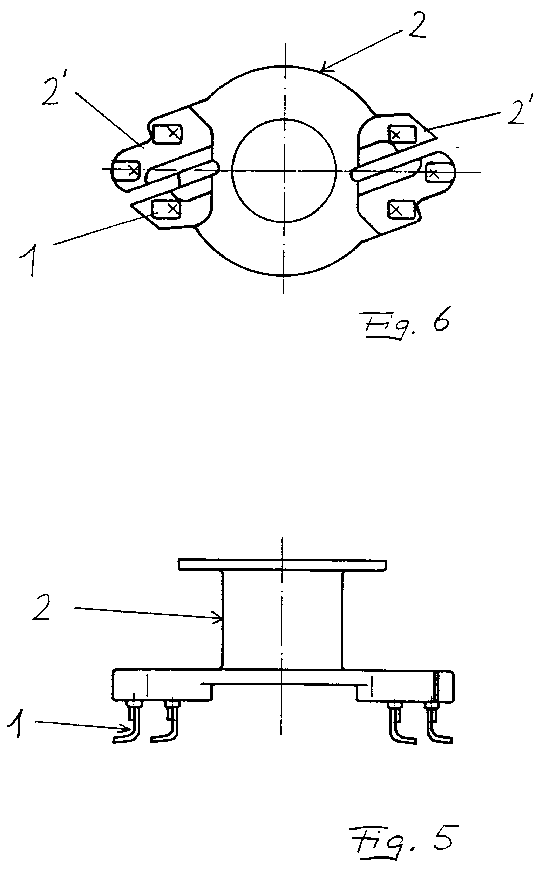

Figur 5 zeigt den Zustand nach dem Abbiegen der Anschlüsse 1 von der Mitte des Spulenkörpers nach außen.

Figur 6 verdeutlicht, daß die Flansche 2′ des Spulenkörpers 2 seitlich angesetzt sind und dort beispielsweise jeweils drei Anschlüsse 1 tragen. Gegen die Anschlüsse 1 kann nach dem Kürzen gemäß Figur 3 auf der Innenseite von unten ein Gegenhalter eingefahren werden, dessen Außenkontur der Position der Anschlüsse 1 angepaßt ist. Sodann können von außen Preßstempel gegen die Anschlüsse 1 gedrückt werden, um die Abplattung gemäß Figur 4 herzustellen.

## Patentansprüche

1. Spulenkörper mit in einem unteren Flansch (2′) eingespritzten Enden (5) von zur Durchsteckkontaktierung geeigneten Anschlußstiften (3), die in einem Abschnitt (4) unterhalb des unteren Flansches (2′) mit Enden von Spulenwickeldrähten umwickelbar sind, **dadurch gekennzeichnet, daß** die Anschlußstifte (3) unterhalb des Abschnitts (4) zu einem rechteckigen Querschnitt (S3) abgeplattet und im Bereich des abgeplatteten Querschnitts (S3) zur Bildung von oberflächenmontierbaren Anschlüssen (1) abgewinkelt sind.

2. Spulenkörper nach Anspruch 1, dadurch gekennzeichnet, daß die Anschlüsse (1) von der Mitte des Spulenkörpers (2) aus im wesentlichen rechtwinkelig nach außen abgewinkelt sind.

3. Spulenkörper nach Anspruch 1 oder 2, dadurch gekennzeichnet, daß durch die Abplattung eine Stufe nur an der Außenseite des Anschlusses (1) ausgebildet ist.

4. Spulenkörper nach einem der Ansprüche 1 bis 3, dadurch gekennzeichnet, daß der umwickelbare Abschnitt (4) zu einem quadratischen Querschnitt (S1) geformt ist.

5. Verfahren zur Herstellung eines Spulenkörpers bei welchem ein herkömmlicher, für die Durchstecktechnik verwendbarer Stift (3) in herkömmlicher Technik im unteren Flansch (2′) des Spulenkörpers (2) verankert wird, dadurch gekennzeichnet, daß das freie Ende (6) des aus dem Flansch (2′) herausstehenden Teils des Anschlußstifts (3) unterhalb des zur Umwicklung vorgesehenen Abschnitts (4) des Anschlußstifts (3) durch Pressen abgeplattet wird und daß der abgeplattete Teil (6) des Anschlußstifts (1) zur Bildung eines oberflächenmontierbaren Anschlusses (1) abgewinkelt wird.

6. Verfahren nach Anspruch 5, bei dem sich die Anschlüsse (1) auf wenigstens zwei Außenseiten des Spulenkörpers (2) befinden, wobei an der Innenseite der Anschlußstifte (3) ein Gegenhalter positioniert wird und mit einem Preßstempel die Anschlußstifte (3) von außen gegen den ortsfest gehaltenen Gegenhalter gedrückt werden.

7. Verfahren nach Anspruch 5 oder 6, dadurch gekennzeichnet, daß der Anschlußstift (3) vor dem Pressen gekürzt wird.

## Claims

1. Bobbin having, injection-moulded in a bottom flange (2′), ends (5) of terminal pins (3), which are suitable for feedthrough contacting and at a portion (4) lying below the bottom flange (2′) may be wrapped with ends of coil winding wires, **characterized in that** the terminal pins (3) below the portion (4) are flattened into a rectangular cross-section (S3) and in the region of the flattened cross-section (S3) are bent at an angle to form surface-mountable connections (1).

2. Bobbin according to claim 1, characterized in that the connections (1) are bent substantially at right angles out from the centre of the bobbin (2).

3. Bobbin according to claim 1 or 2, characterized in that as a result of the flattening a step is formed only at the outside of the connection (1).

4. Bobbin according to one of claims 1 to 3, characterized in that the wrappable portion (4) is shaped into a square cross-section (S1).

5. Method of manufacturing a bobbin, in which a conventional pin (3) usable for the feedthrough technique is anchored in a conventional manner in the bottom flange (2′) of the bobbin (2), characterized in that the free end (6) of the part of the terminal pin (3) projecting from the flange (2′) is flattened by pressing below the portion (4) of the terminal pin (3) intended for wrapping and that the flattened part (6) of the terminal pin (1) is bent at an angle to form a surface-mountable connection (1).

6. Method according to claim 5, wherein the connections (1) are situated at at least two outer sides of the bobbin (2), whereby a pressure pad is positioned against the inside of the terminal pins (3) and held stationary while the terminal pins (3) are pressed from the outside against the pressure pad by a pressure ram.

7. Method according to claim 5 or 6, characterized in that the terminal pin (3) is shortened prior to pressing.

## Revendications

1. Corps de bobine comportant, injectées dans un flasque inférieur (2′), des extrémités (5) de broches de connexion (3), broches qui sont appropriées pour la mise en contact par traversée, et ont en-dessous du flasque inférieur (2′) une région (4) sur laquelle peuvent être enroulées des extrémités de fils d'enroulement de bobine, caractérisé en ce que sous ladite région (4) les broches de connexion (3) sont aplaties en une section transversale rectangulaire (S3) et dans la zone de la section transversale aplatie (S3) sont coudées pour constituer des connexions pouvant être montées en surface (1).

2. Corps de bobine selon la revendication 1, caractérisé en ce que les connexions (1) sont coudées sensiblement à angle droit vers l'extérieur à partir du milieu du corps de bobine (2).

3. Corps de bobine selon la revendication 1 ou 2, caractérisé en ce que l'aplatissement ne donne lieu à un épaulement que du côté extérieur de la connexion (1).

4. Corps de bobine selon l'une des revendications 1 à 3, caractérisé en ce que la région d'enroulement (4) est formée pour avoir une section transversale carrée (S1).

5. Procédé pour fabriquer un corps de bobine, dans lequel on fixe selon la technique classique dans le flasque inférieur (2′) du corps de bobine (2), une broche (3) classique, utilisable pour la technique de traversée caractérisé en ce qu'on aplatit à la presse, au-dessous de la région (4) prévue pour l'enroulement, l'extrémité libre (6) de la partie de la broche de connexion (3) qui dépasse du flasque (2′), et en ce qu'on coude la partie aplatie (6) de la broche de connexion (1) pour constituer une connexion (1) pouvant être montée en surface.

6. Procédé selon la revendication 5, dans lequel les connexions (1) se trouvent sur au moins deux côtés extérieurs du corps de bobine (2), procédé dans lequel on positionne une matrice mobile du côté intérieur des broches de connexion (3), et au moyen d'un poussoir de presse, on presse les broches de connexion (3) de l'extérieur contre la matrice mobile maintenue fixe.

7. Procédé selon la revendication 5 ou 6, caractérisé en ce qu'on raccourcit la broche de connexion (3) avant le pressage.
